(19) Europäisches Patentamt
European Patent Office
Office européen des brevets

(11) Veröffentlichungsnummer: **0 443 153 A1**

(12) **EUROPÄISCHE PATENTANMELDUNG**

(21) Anmeldenummer: **90124404.6**

(22) Anmeldetag: **17.12.90**

(51) Int. Cl.[5]: **G03F 7/027**, G03F 7/075, C08F 2/50, C08L 53/00

(30) Priorität: **19.01.90 DE 4001465**

(43) Veröffentlichungstag der Anmeldung: **28.08.91 Patentblatt 91/35**

(84) Benannte Vertragsstaaten: **CH DE FR GB IT LI NL**

(71) Anmelder: **HOECHST AKTIENGESELLSCHAFT**
**Postfach 80 03 20**
**W-6230 Frankfurt am Main 80(DE)**

(72) Erfinder: **Gersdorf, Joachim, Dr. Dipl.-Chem.**
**Lohmühlweg 17**
**W-6200 Wiesbaden(DE)**

(54) **Strahlungsempfindliches Gemisch basierend auf oligomeren Malein- und Fumarsäureestern und daraus erhaltenes Aufzeichnungsmaterial für die Herstellung von Reliefdruckplatten.**

(57) Die Erfindung betrifft ein strahlungsempfindliches Gemisch enthaltend als wesentliche Bestandteile

a) mindestens ein thermoplastisches elastomeres Blockcopolymeres der allgemeinen Formeln

$(A\text{-}B)_m\text{-}A$, $(B\text{-}A)_{m+1}\text{-}B$, $(A\text{-}B)_{m+1}$ oder $(A\text{-}B)_oY$,

worin

- A für einen thermoplastischen, nicht-elastomeren Polymerblock mit einer Glasübergangstemperatur von 25 °C oder darüber und
- B für einen elastomeren Polymerblock mit einer Glasübergangstemperatur von 10 °C oder darunter stehen,
- Y Sn oder Si ist,
- m eine ganze Zahl von 1 bis 10 darstellt und
- o 2 ist, wenn X Sn ist oder 4, wenn X Si ist,

b) mindestens eine mehrfach ethylenisch ungesättigte Verbindung und

c) einen Photopolymerisationsinitiator,

das dadurch gekennzeichnet ist, daß mindestens eine der mehrfach ethylenisch ungesättigten Verbindungen der allgemeinen Formel I

$$R-(O-\overset{O}{\overset{\|}{C}}-CH=CH-\overset{O}{\overset{\|}{C}}-O-X)_n-O-\overset{O}{\overset{\|}{C}}-CH=CH-\overset{O}{\overset{\|}{C}}-O-R \qquad (I)$$

entspricht, wobei

- R einen geradkettigen oder verzweigten Alkylrest,
- X ein geradkettiges Alkylen oder Cycloalkylen, wobei einzelne Methylengruppen durch -O-, -S-, Carbonyl- oder Carbonyloxygruppen substituiert sein können, und
- n 1 bis 5

bedeuten.

Das Gemisch ermöglicht die Herstellung von Relief- und Flexodruckplatten mit einer hohen Shore-A-Härte. Die den Druckplatten zugrunde liegenden Aufzeichnungsschichten sind lagerstabil und zeigen eine hohe

EP 0 443 153 A1

Lichtempfindlichkeit.

# STRAHLUNGSEMPFINDLICHES GEMISCH BASIEREND AUF OLIGOMEREN MALEIN- UND FUMARSÄUREESTERN UND DARAUS ERHALTENES AUFZEICHNUNGSMATERIAL FÜR DIE HERSTELLUNG VON RELIEFDRUCKPLATTEN

Diese Erfindung betrifft ein durch Strahlung polymerisierbares Gemisch, enthaltend ein polymeres Bindemittel, mindestens eine mehrfach ethylenisch ungesättigte Verbindung und einen Photopolymerisationsinitiator sowie ein Aufzeichnungsmaterial, enthaltend dieses strahlungsempfindliche Gemisch.

Photopolymerisierbare Gemische zur Herstellung von Reliefdruckformen, die z. B. beim Flexodruckverfahren eingesetzt werden, enthalten ein polymeres Bindemittel, eine radikalisch polymerisierbare Verbindung und einen Photopolymerisationsinitiator. Unter Belichtung wird das Gemisch vernetzt und unlöslich. Die verwendeten, radikalisch polymerisierbaren Verbindungen sind Ester ungesättigter Carbonsäuren, insbesondere der Acryl- und Methacrylsäure, mit mehrwertigen Alkoholen, die gegebenenfalls Urethan- oder Ethergruppen enthalten können.

In der DE-B 22 15 090 (= US-A 4 423 135) wird ein Gemisch aus einem thermoplastischen elastomeren Dreiblockcopolymeren, einem Photopolymerisationsinitiator und einer ethylenisch ungesättigten Verbindung mit mindestens einer endständigen ethylenisch ungesättigten Gruppe beschrieben. Das Gemisch besitzt aber nur eine geringe thermische Stabilität. Dies äußert sich zum Beispiel darin, daß bei der thermoplastischen Verarbeitung während der Herstellung einer unbelichteten Druckplatte und bei gleichzeitigem Einfluß von Scherkräften oder einer Lagerung bei relativ hohen Temperaturen in Lösemitteln - sogar bei Zusatz eines Hitzepolymerisationsinhibitors - unlösliche Formen entstehen. Die Qualität einer aus diesem strahlungsempfindlichen Gemisch erzeugten Reliefdruckplatte ist deshalb stark vermindert. In Extremfällen läßt sich überhaupt kein Relief mehr erzeugen. Bei den in der DE-B 22 15 090 beschriebenen ethylenisch ungesättigten Verbindungen mit mindestens einer endständigen ethylenisch ungesättigten Gruppe handelt es sich insbesondere um (Meth)acrylsäureester, wie z. B. das 1,6-Hexandioldiacrylat. Diese Verbindungen sind relativ leicht flüchtig und verursachen beim Menschen bekanntermaßen Reizungen der Augen, der Atmungsorgane und der Haut.

In der DE-B 28 15 678 (= US-A 4 197 130) wird ein lichtempfindliches Gemisch aus einem thermoplastischen elastomeren Blockcopolymeren, einem Photopolymerisationsinitiator und mindestens einer ethylenisch ungesättigten Verbindung beschrieben. Als ethylenisch ungesättigte Verbindungen werden Diester aus Fumarsäure bzw. Maleinsäure mit monofunktionellen Alkoholen, z. B. Fumarsäure- bis -(2-ethylhexylester), beschrieben. Ein großer Nachteil der Gemische, die diese ungesättigten Verbindungen enthalten, ist deren geringe Lichtempfindlichkeit, insbesondere im Vergleich zu Gemischen mit Hexandioldiacrylat. Die Ursache ist darin zu suchen, daß 1,2-disubstituierte ethylenisch ungesättigte Monomere eine geringere polymerisationsreaktivität besitzen als 1,1-disubstituierte ethylenisch ungesättigte Monomere (T. Otsu et al., Makromol. Chem., Rapid Commun. 2, 725 (1981) und T. Otsu, Makromol. Symp. 10/11, 235 (1987)). Weiterhin hängt die Lichtempfindlichkeit von photopolymerisierbaren Gemischen von der Funktionalität der Monomeren ab: Hohe Vernetzungsgeschwindigkeiten lassen sich bekanntermaßen nur mit mehrfunktionellen Monomeren erreichen (C. G. Roffey, photopolymerization of Surface Coatings, Wiley-Interscience, New York 1982, und H. Barzynski et al., Chemiker-Zeitung 96, 545 (1972)).

Aufgabe der vorliegenden Erfindung war es daher, ein durch Strahlung polymerisierbares Gemisch bereitzustellen, das trotz hoher Lager- und Wärmebeständigkeit eine große Vernetzungsgeschwindigkeit bei Belichtung zeigt. Gleichzeitig soll gewährleistet sein, daß die Bestandteile des polymerisierbaren Gemisches eine gute Verträglichkeit untereinander aufweisen und im Vergleich mit Gemischen, die (Meth)-acrylsäureester enthalten, eine geringere Flüchtigkeit und eine geringere Reizwirkung besitzen.

Erfindungsgemäß wird ein durch Strahlung polymerisierbares Gemisch bereitgestellt, enthaltend als wesentliche Bestandteile

a) mindestens ein thermoplastisches elastomeres Blockcopolymeres der allgemeinen Formeln $(A\text{-}B)_m\text{-}A$, $(B\text{-}A)_{m+1}\text{-}B$, $(A\text{-}B)_{m+1}$ oder $(A\text{-}B)_oY$,

worin

- A für einen thermoplastischen, nicht-elastomeren Polymerblock mit einer Glasübergangstemperatur von 25 °C oder darüber und
- B für einen elastomeren Polymerblock mit einer Glasübergangstemperatur von 10 °C oder darunter stehen,
- Y Sn oder Si ist,
- m eine ganze Zahl von 1 bis 10 darstellt und
- o 2 ist, wenn X Sn ist oder 4, wenn X Si ist,

b) mindestens eine mehrfach ethylenisch ungesättigte Verbindung und

c) einen Photopolymerisationsinitiator,
das dadurch gekennzeichnet ist, daß mindestens eine der mehrfach ethylenisch ungesättigten Verbindungen der allgemeinen Formel I

$$R-(O-\overset{O}{\overset{\|}{C}}-CH=CH-\overset{O}{\overset{\|}{C}}-O-X)_n-O-\overset{O}{\overset{\|}{C}}-CH=CH-\overset{O}{\overset{\|}{C}}-O-R \qquad (I)$$

entspricht, wobei

- R einen geradkettigen oder verzweigten Alkylrest,
- X ein geradkettiges Alkylen oder Cycloalkylen, wobei einzelne Methylengruppen durch -O-, -S-, Carbonyl- oder Carbonyloxygruppen substituiert sein können, und
- n 1 bis 5

bedeuten.

Bevorzugt sind solche Verbindungen gemäß Formel I, deren Alkylen (X), sofern es Heteroatome enthält, durch -O- oder Carbonyloxy- substituiert ist. Besonders bevorzugt sind von den durch Heteroatome substituierten Alkylenresten solche, bei denen nur gleichartige Heteroatome vorhanden sind. Sofern eine Methylengruppe durch eine Carbonyloxygruppe ersetzt ist, weist der diesen Substituenten enthaltende Alkylrest vorzugsweise nur eine solche Gruppe auf.

Für R steht insbesondere

- ein Alkylrest mit 1 bis 8, vorzugsweise mit 1 bis 4, C-Atomen. Hierunter sind besonders bevorzugt diejenigen Alkylreste, die geradkettig sind. Insgesamt werden solche Verbindungen gemäß der allgemeinen Formel I bevorzugt, deren beide Reste R gleich sind.

Für X sollen genannt werden

- verzweigte oder geradkettige Alkylenreste mit 2 bis 20 C-Atomen, insbesondere mit 4 bis 15 C-Atomen, besonders bevorzugt geradkettige Alkylenreste,
- verzweigte oder geradkettige Polyole, insbesondere geradkettige mit 1 bis 12, bevorzugt mit 1 bis 6, wiederkehrenden Einheiten der Formel $[OA]_{n\text{-}}$, worin A Alkylen mit 2 bis 4 C-Atomen darstellt,
- cycloaliphatisches Alkylen mit vorzugsweise 6 bis 12 C-Atomen, insbesondere mit 6 C-Atomen - wie Cyclohexyliden, speziell 1,4-Cyclohexyliden - bzw. mit 7 oder 8 C-Atomen, wie $-CH_2-C_6H_{10}-$ und $-CH_2-C_6H_{10}-CH_2-$, wobei $C_6H_{10}$ für Cyclohexyliden, speziell für 1,4-Cyclohexyliden, steht,
- Alkylen mit mindestens einer Carbonyloxygruppe, insbesondere verzweigtes Alkylen, wobei die Alkylenreste, die jeweils eine Carbonyloxygruppe flankieren, mindestens 3 C-Atome, vorzugsweise mindestens 4 C-Atome und höchstens jeweils 6 C-Atome, aufweisen, vorzugsweise Alkylen mit einer Carbonyloxygruppe.

Das Molekulargewicht (zahlenmäßig) der Verbindungen gemäß der allgemeinen Formel I beträgt maximal 5.000, vorzugsweise maximal 3.000 und insbesondere maximal 1.600. In speziellen Fällen und in Abhängikeit von den übrigen Bestandteilen des erfindungsgemäßen strahlungsempfindlichen Gemisches kann ein Molekulargewicht von maximal unter 1.000 vorteilhaft sein. Ebenso zeichnen sich die erfindungsgemäß verwendeten Verbindungen gemäß allgemeiner Formel I dadurch aus, daß sie eine OH-Zahl von kleiner als 1 mg KOH/g aufweisen.

Die mehrfach ethylenisch ungesättigten Verbindungen der allgemeinen Formel I enthalten mindestens 2 und höchstens 6 C-C-Doppelbindungen.

Das erfindungsgemäße strahlungsempfindliche Gemisch enthält als mehrfach ungesättigte Verbindung mindestens 85 Gew.-%, insbesondere mindestens 90 Gew.-% und vorzugsweise mindestens 99 Gew.-% einer Verbindung der allgemeinen Formel I. Die jeweilige Differenz zu 100 Gew.-% besteht u.a. aus mehrfach ungesättigten Verbindungen, bei denen ein bestimmter Anteil des Restes R durch X-OH ersetzt ist. Mithin handelt es sich bei diesen Verbindungen um nicht vollständig in Verbindungen gemäß der allgemeinen Formel I abreagierte Zwischenprodukte. Darüber hinaus können im Gemisch der mehrfach ungesättigten Verbindungen neben denen gemäß der allgemeinen Formel I - in untergeordneter Weise - auch solche enthalten sein, bei denen n größer als 5 ist.

Bei den ethylenisch ungesättigten Verbindungen der allgemeinen Formel I handelt es sich um Oligoester der Fumarsäure bzw. Maleinsäure. Sie erfüllen ein wichtiges Kriterium, das für Photopolymerschichten gilt, sie müssen eine hohe Transparenz für Strahlung im sichtbaren und ultravioletten Wellenlängenbereich aufweisen. Störende Trübungen werden z. B. durch eine Unverträglichkeit des Bindemittels mit dem Monomeren hervorgerufen. Insbesondere ist dieser Effekt bei Oligoestern und Polyestern der Fumarsäure bzw. Maleinsäure zu beobachten, die endständige Carboxylgruppen (R = H in der allgemeinen Formel I) aufweisen, oder ein zu großes n (n > 5) zeigen. Die erfindungsgemäß verwendeten ethylenisch ungesättigten Verbindungen gemäß der allgemeinen Formel I zeigen dagegen eine sehr große Anwendungsbreite. Insbesondere sind Mischungen mit unterschiedlichen Bindemitteln möglich, ohne Minderungen der Transparenz hervorzurufen.

Die Synthesemethode sollte daher so ausgewählt bzw. modifiziert sein, daß sie reproduzierbare Produkte gewährleistet, die den Anforderungen der allgemeinen Formel I genügen. Insbesondere sind darunter das gemäß der allgemeinen Formel I geforderte geringe Zahlenmittel-Molekulargewicht und eine enge Molekulargewichtsverteilung zu verstehen.

Prinzipiell können die Oligoester der allgemeinen Formel I mit den bekannten Methoden der organischen präparativen Chemie zur Estersynthese hergestellt werden, z. B.

- durch Umsetzung von Carbonsäurechloriden und/oder Carbonsäureesterchloriden mit den entsprechenden alkoholgruppenhaltigen Verbindungen (vgl. A. Matsumoto et al., J. Polym. Sci. Polym. Chem. Ed. 21 (1983), 3191),
- durch direkte Veresterung von carboxylgruppenhaltigen Verbindungen, wobei auch Fumarsäuremonoester und Bisfumarsäuremonoester, wie sie z. B. in der EP-A 0 069 926 beschrieben sind, als carboxylgruppenhaltige Verbindungen eingesetzt werden können,
- durch Umesterung, z. B. von Fumarsäurediestern mit Diolen in Gegenwart eines Katalysators.

Als vorteilhaft hat sich die Umesterungsmethode erwiesen, bei der - eventuell im Überschuß - Fumarsäure-dialkylester ROOC-CH = CH-COOR, insbesondere Fumarsäure-di-n-butylester, zusammen mit einem Katalysator bei erhöhter Temperatur, vorgelegt wird und ein Diol HO-X-OH mehr oder weniger schnell, eventuell portionsweise, zugegeben wird und der nach der Reaktionsgleichung

$$n+1\ ROOC\text{-}CH=CH\text{-}COOR\ +\ n\ HO\text{-}X\text{-}OH$$
$$\rightarrow R\text{-}(\text{-}OOC\text{-}CH=CH\text{-}COO\text{-}X\text{-})_n\text{-}OOC\text{-}CH=CH\text{-}COOR\ +\ 2n\ ROH$$

entstehende Alkohol ROH, z. B. n-Butanol, aus dem Reaktionsgemisch durch Anlegen von Vakuum entfernt wird. Als Umesterungskatalysator können die literaturbekannten Verbindungen eingesetzt werden (vgl. Houben-Weyl, Methoden der Organischen Chemie, Bd. 8, S. 702 ff.). Als vorteilhaft hat sich das schon bei ähnlichen Reaktionen bewährte Dioctylzinnoxid erwiesen (DE-A 27 52 109): Es werden hohe Umsätze erzielt, die OH-Zahlen der Produkte sind kleiner als 1 mg KOH/g. Eventuelle Überschüsse an eingesetzten Fumarsäurediester werden anschließend durch vakuumdestillation abgetrennt. Eine weitere Aufarbeitung des Reaktionsprodukts ist in der Regel nicht notwendig.

Die entstehenden, meist flüssigen oder wachsartigen Oligofumarate werden in einem Anteil von 1 bis 40 Gew.-% , vorzugsweise von 2 bis 20 Gew.-%, im erfindungsgemäßen strahlungsempfindlichen Gemisch eingesetzt.

Bei den im erfindungsgemäßen strahlungsempfindlichen Gemisch enthaltenen polymeren Bindemitteln handelt es sich um thermoplastische elastomere Blockcopolymere der allgemeinen Formeln

$(A\text{-}B)_m\text{-}A$, $(B\text{-}A)_{m+1}\text{-}B$, $(A\text{-}B)_{m+1}$ oder $(A\text{-}B)_oY$,

in denen A für einen thermoplastischen, nicht-elastomeren Polymerblock mit einer Glasübergangstemperatur von 25 °C oder darüber und B für einen elastomeren Polymerblock mit einer Glasübergangstemperatur von höchstens 10 °C stehen, Y Sn oder Si ist, m eine ganze Zahl von 1 bis 10 darstellt und o = 2 ist, wenn Y Sn ist und o = 4, wenn Y Si ist. Bei den Blöcken A handelt es sich vorzugsweise um solche, die durch Polymerisation von alkenylaromatischen Kohlenwasserstoffen (vorzugsweise vinylsubstituierten aromatischen Kohlenwasserstoffen, insbesondere monocyclischen vinylaromatischen Kohlenwasserstoffen) hergestellt werden, während die Blöcke B Polymere von aliphatischen konjugierten Diolefinen darstellen. Besonders bevorzugt als Block A werden Polystyrol und Poly-(α-methylstyrol) sowie als Block B Polybutadien und Polyisopren.

Spezielle Beispiele für $(A\text{-}B)_m\text{-}A$ sind Polystyrol-Polybutadien-Polystyrol, Polystyrol-Polyisopren-Polystyrol, Poly-(α-methylstyrol )-Polybutadien-Poly-(α-methylstyrol), Polystyrol-Polybutadien-Polystyrol-Polybutadien-Polystyrol, Polystyrol-Butadien-Polystyrol-Butadien-Polystyrol-Butadien-Polystyrol und deren analoge Blockpolymere, bei denen die Häufigkeit m der wiederkehrenden Einheiten (A-B) bis zu 10 beträgt.

Spezielle Beispiele für $(B\text{-}A)_{m+1}\text{-}B$ sind Polybutadien-Polystyrol-Polybutadien-Polystyrol-Polybutadien, Polyisopren-Polystyrol-Polyisopren-Polystyrol-Polyisopren und deren analoge Blockpolymere, bei denen die Häufigkeit m der wiederkehrenden Einheiten (B-A) bis zu 10 beträgt.

Spezielle Beispiele für $(A\text{-}B)_{m+1}$ sind Polystyrol-Polybutadien-Polystyrol-Polybutadien, Polystyrol-Polyisopren-Polystyrol-Polyisopren, Poly-(α-methylstyrol)-Polybutadien-Poly-(α-methylstyrol)-Polybutadien, Polystyrol-Polybutadien-Polystyrol-Polybutadien-Polystyrol-Polybutadien und deren analoge Blockpolymere, bei denen die Häufigkeit m der wiederkehrenden Einheiten (A-B) bis zu 10 beträgt.

Spezielle Beispiele für $(A\text{-}B)_oY$ sind (Polystyrol-Polybutadien)$_4$Si, (Polystyrol-Polyisopren)$_4$Si und (Polystyrol-Polybutadien)$_2$Sn.

Beispiele für erfindungsgemäß verwendbare thermoplastische elastomere Blockcopolymere sind auch die in den US-A 3 265 765 und GB-A 1 366 769 beschriebenen Copolymere. Diese Copolymere können einzeln oder in Kombination eingesetzt werden.

Von diesen Copolymeren werden solche mit m = 1 bevorzugt, weil diese eine hohe Kautschukelastizität aufweisen und leicht verfügbar sind. Bevorzugt werden z. B. Polystyrol-Polyisopren-Polystyrol,Polystyrol-Polybutadien-Polystyrol und Polystyrol-Polybutadien-Polystyrol-Polybutadien.

Aus den gleichen Gründen wird (Polystyrol-Polybutadien)$_4$Si von den Copolymeren der allgemeinen Formel $(A\text{-}B)_oY$ bevorzugt.

Das Molekulargewicht (Zahlenmittel) des thermoplastischen, nicht-elastomeren Polymerblocks beträgt bevorzugt 2.000 bis 100.000, das Molekulargewicht (Zahlenmittel) des elastomeren Polymerblocks 25.000 bis 1.000.000.

Der Anteil des thermoplastischen elastomeren Blockcopolymeren im erfindungsgemäßen strahlungsempfindlichen Gemisch beträgt 30 bis 98 Gew.-%, insbesondere 50 bis 96 Gew.-%.

Als Photoinitiatoren in dem erfindungsgemäßen Gemisch können eine Vielzahl von Substanzen Verwendung finden. Beispiele sind solche, die sich vom Grundkörper der Benzophenone, Acetophenone, Benzoine, Benzile, Benzilmonoketale, Benzildiketale, des Fluorenons und Thioxanthons, der Mehrkernchinone, Acridine und Chinoxaline ableiten; ferner Trichlormethyl-s-triazine, 2-Halogenmethyl-5-vinyl-1,3,4-oxadiazolderivate, mit Trichlormethylgruppen substituierte Halogenoxazole, Trihalogenmethylgruppen enthaltende Carboxymethylenheterocyclen gemäß DE-A 33 33 450, Acylphosphinoxyverbindungen, wie sie z. B. in der DE-A 31 33 419 beschrieben sind, und andere phosphorhaltige Photoinitiatoren, z. B. die in der älteren deutschen Patentanmeldung P 38 27 735.2 beschriebenen 6-Acyl-6H-dibenzo[c,e][1,2]oxaphosphorin-6-oxide, insbesondere das 6-(2,4,6-Trimethylbenzoyl)-6H-dibenzo-[c,e][1,2]oxaphosphorin-6-oxid. Die Photoinitiatoren lassen sich auch in Kombination miteinander oder mit Coinitiatoren bzw. Aktivatoren verwenden, z. B. mit Michlers' Keton und seinen Derivaten oder 2-Alkyl-anthrachinonen.

Die Menge an Photoinitiator beträgt im allgemeinen etwa 0,01 bis 10 Gew.-%, bevorzugt etwa 0,5 bis 5 Gew.-%, des erfindungsgemäßen strahlungsempfindlichen Gemisches.

Oft ist es von Vorteil, dem strahlungsempfindlichen Gemisch noch weitere Hilfs- und Zusatzstoffe zuzugeben, z. B. Inhibitoren der thermischen Polymerisation wie Hydrochinon und seine Derivate, 2,6-Di-tert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Farbstoffe, Pigmente, Verarbeitungshilfsmittel und Weichmacher.

Das erfindungsgemäße Gemisch läßt sich für die Herstellung von Relief- und Flexodruckplatten durch Gießen aus Lösung oder Extrudieren und Kalandrieren zu Schichten einer Dicke von 0,02 bis 10, vorzugsweise von 0,2 bis 7,0 mm, ausformen. Die Schicht kann auf die Oberfläche eines geeigneten Trägers z. B. durch Kalandrierung laminiert werden oder die Lösung des erfindungsgemäßen Gemisches auf einen Schichtträger aufgebracht werden. Geeignete Träger sind z. B. Polyesterfolien, Stahl- oder Aluminiumbleche, Schaumstofflagen oder gummielastische Träger. Eine Vorbeschichtung des Schichtträgers kann vorteilhaft sein. Die durch die Vorbeschichtung entstehende zusätzliche Schicht zwischen dem Träger und der strahlungsempfindlichen Schicht kann z. B. als Lichthofschutzschicht oder als Haftschicht wirksam sein. Es kann vorteilhaft sein, auf die strahlungsempfindliche Aufzeichnungsschicht eine dünne Deckschicht, z. B. eine Polyamidschicht und/oder eine abziehbare Schutzfolie, z. B. aus Polyethylenglykolterephthalat, aufzubringen. Auch dies kann durch Kalandrierung erfolgen.

Insbesondere wird die Herstellung von Relief- und Flexodruckplatten durch ein kombiniertes Extrudier- und Kalandrierverfahren ermöglicht, bei dem die Schmelze aus einem Extruder, insbesondere einem Zweischneckenextruder, über eine Breitschlitzdüse in den Kalanderspalt eines Zweiwalzenkalanders hineingeführt wird. In diesem Spalt wird die gewünschte Dicke ausgebildet. Zusätzlich lassen sich über die beiden Walzen sowohl die Trägerfolie als auch die Deckschicht mit einführen, so daß nach dem Verlassen des Kalanders das endgültige Mehrschichtenelement vorliegt. Ein entsprechendes Verfahren ist in der EP-A 0 080 665 beschrieben.

Das Mehrschichtenelement erfährt anschließend vorzugsweise eine vollflächige Rückseitenbelichtung, damit sich ein stabiler Sockel der Druckplatte ausbildet. Die lichtempfindliche bildmäßige Belichtung erfolgt anschließend. Hierzu wird das erfindungsgemäße Aufzeichnungsmaterial bildmäßig mit aktinischem Licht aus Lichtquellen wie Quecksilberdampflampen oder Leuchtstoffröhren belichtet, wobei die emittierte Wellenlänge bevorzugt zwischen 300 und 420 nm liegt. Das Entfernen der unbelichteten und unvernetzten Schichtanteile kann durch Sprühen, Waschen oder Bürsten mit einem geeigneten Lösemittel, z. B. 1,1,1-Trichlorethan, Tetrachlorethan, Toluol und Gemische eines dieser Lösemittel mit höchstens 50 Gew.-% eines Alkohols, z. B. n-Butanol, erfolgen. Zweckmäßig werden die entwickelten Reliefformen bei Temperaturen bis 120 °C getrocknet und gegebenenfalls gleichzeitig oder danach mit aktinischem Licht nachbelichtet.

Das erfindungsgemäße Aufzeichnungsmaterial eignet sich insbesondere zur Herstellung von Druckformen, vor allem von Hoch- oder Reliefdruckformen, die besonders für den Flexodruck geeignet sind.

Die erfindungsgemäßen strahlungsempfindlichen Gemische, die als mehrfach ungesättigte Verbindungen die Verbindungen der allgemeinen Formel I enthalten, zeichnen sich überraschenderweise durch eine höhere Lichtempfindlichkeit aus als vergleichbare Mono- bzw. Diester der entsprechenden Furmar- bzw. Maleinsäure. Auf der anderen Seite weisen sie aber eine höhere Lager- und Wärmebeständigkeit auf als die üblichen Acrylsäure- bzw. Methacrylsäurederivate und sind gegenüber diesen auch hinsichtlich ihrer geringen Flüchtigkeit und Reizung vorteilhaft. Das vorliegende erfindungsgemäße strahlungsempfindliche Gemisch weist daher nur die Vorteile aller bisher bekannten Monomeren auf, ohne jedoch auch deren Nachteile zu zeigen. Hinzu kommt noch, daß die erfindungsgemäßen Gemische die Herstellung von Reliefdruckplatten ermöglichen, die eine hohe Shore-A-Härte aufweisen. Sie liegt höher als 34 (DIN 53 505).

Die Erfindung wird durch die nachstehenden Beispiele erläutert.

Herstellungsbeispiel 1

| | | |
|---|---|---|
| 182,6 | Gt | Fumarsäure-di-n-butylester, |
| 57,4 | Gt | eines verzweigten Alkandiols mit primären Hydroxylgruppen und 15 C-Atomen ((R)Diol 100 der Firma Sartomer Co., OH-Zahl 380 mg KOH/g), |
| 1,0 | Gt | 2,6-Di-tert.-butyl-p-kresol und |
| 0,4 | Gt | Di-n-Octylzinnoxid |

werden in einem Glaskolben unter Rühren in einem Ölbad auf 110 °C erhitzt. Bei einem Vakuum von 25 Torr wird innerhalb von 3 Stunden das entstehende n-Butanol abdestilliert. Anschließend wird bei einem Vakuum von 0,01 mbar und einer Ölbadtemperatur von 150 °C der Überschuß an Fumarsäure-di-n-butylester abdestilliert. Als Rückstand werden 108,2 g eines öligen Produkts erhalten mit einer OH-Zahl von kleiner als 1 mg KOH/g.

Herstellungsbeispiele 2 bis 9

1,0 Gt 2,6-Di-tert.-butyl-p-kresol, 0,4 Gt Di-n-octylzinnoxid und die in Tabelle I jeweils aufgeführten Mengen an Fumarsäure-di-n-butylester und Alkandiol werden analog zu Herstellungsbeispiel 1 umgesetzt und anschließend aufgearbeitet. Die OH-Zahlen der Produkte sind kleiner als 1 mg KOH/g. Die Ergebnisse sind in Tabelle I zusammengefaßt.

Tabelle I

| Herstellungsbeispiel | Fumarsäure-di-n-butylester (Gt) | Alkandiol (Gt) | Alkandiol |
|---|---|---|---|
| 2 | 182,6 | 20,8 | 2,2-Dimethyl-1,1-propandiol |
| 3 | 137,0 | 23,6 | 1,6-Hexandiol |
| 4 | 182,6 | 23,6 | 1,6-Hexandiol |
| 5 | 200,6 | 31,7 | 1,4-Bis-(hydroxymethyl)-cyclohexan |
| 6 | 200,6 | 31,7 | 1,4-Bis-(hydroxymethyl)-cyclohexan* |
| 7 | 182,6 | 130,0 | Polytetramethylenetherglykol** |
| 8 | 137,0 | 40,9 | 1-Hydroxypivalinsäureneopentylglykolester |
| 9 | 182,6 | 32,0 | 2-Ethyl-2-butyl-1,3-propandiol |

* Kontinuierliche Zugabe des Diols bei 110 °C Ölbadtemperatur innerhalb von 3 Stunden
** Polytetrahydrofuran 650 der BASF AG, OH-Zahl 166 mg KOH/g.

Anwendungsbeispiel 1

| | | |
|---|---|---|
| 94 | Gt | eines Styrol-Isopren-Styrol-Dreiblockcopolymeren mit 15 % Styrolgehalt ((R)Europrene SOL T 190 der Firma Enichem), |
| 4 | Gt | des in Herstellungsbeispiel 1 beschriebenen Fumarsäureoligoesters, |
| 0,3 | Gt | 2,6-Di-tert.-butyl-p-kresol und |
| 2 | Gt | Benzildimethylketal werden in |
| 100 | Gt | Toluol |

gelöst und auf eine 0,125 mm dicke Polyethylenglykolterephthalatfolie zu einer 6,0 mm dicken Schicht gegossen. Nach Verdunsten des Toluols wird die Polyethylenglykolterephthalatfolie abgezogen und die verbleibende 3,0 mm dicke Photopolymerschicht in einer Plattenpresse bei 120 °C 10 min zwischen zwei vorbeschichteten Polyethylenglykolterephthalatfolien gepreßt. Die Polyesterfolien sind derart vorbeschichtet, daß sich bei dem entstehenden Mehrschichtenelement zwischen der Photopolymerschicht und einer

Polyesterfolie, die als Schutzfolie dient, eine 0,005 mm dicke Copolyamidschicht ((R)Makromelt 6900 der Firma Henkel) als Deckschicht ausbildet. Ebenso entsteht zwischen der Photopolymerschicht und der zweiten Polyesterfolie, die als Träger folie dient, eine 0,0005 mm dicke Haftschicht, wie sie in der DE-A 37 40 432 beschrieben ist. Nach dem Heißpressen beträgt die Dicke der Photopolymerschicht 2,53 mm. Die Photopolymerschicht wird nun ohne Bildvorlage (Rückseitenbelichtung) mit einem UVA-Flachbelichter (Emissionswellenlängenbereich 320 bis 400 nm, Intensität 10,7 mW/cm$^2$) und bildmäßig von der gegenüberliegenden Seite nach Abziehen der Polyester-Schutzfolie und Auflegen eines Bildnegativs auf die Copolyamid-Deckschicht belichtet.

Zur Bestimmung der Mindestbelichtungszeit, d.h. der Zeit, die notwendig ist, um das auf einem Standardnegativ vorhandene 0,055-mm-Liniengitter exakt auf der herzustellenden Druckplatte abzubilden, wird stufenweise durch ein Standardnegativ belichtet. Nach dem Auswaschen der unbelichteten Bildstelle mit Tetrachlorethen/n-Butanol 4:1 wird 10 min nachbelichtet.

Zur Herstellung einer Flexodruckplatte mit einer Gesamtdicke von 2,66 mm, einer Relieftiefe von 1,1 mm und einer einwandfreien Reliefausbildung des 0,055-mm-Liniengitters ist eine Rückseitenvorbelichtung von 148 s und eine Mindest-Bildbelichtungszeit von 13 min notwendig. Die Härte nach Shore-A der strahlungsvernetzten Photopolymerschicht beträgt 46.

Anwendungsbeispiele 2 bis 9

| | | |
|---|---|---|
| 94 | Gt | des in Anwendungsbeispiel 1 beschriebenen Dreiblockcopolymeren, |
| 4 | Gt | eines der in Herstellungsbeispielen 2 bis 9 beschriebenen Fumarsäureoligoesters, |
| 0,3 | Gt | 2,6-Di-tert.-butyl-p-kresol und |
| 2 | Gt | Benzildimethylketal |

werden wie in Anwendungsbeispiel 1 beschrieben zu einer Flexodruckplatte mit einer Gesamtdicke von 2,66 mm verarbeitet. Die jeweils notwendigen Rückseitenvorbelichtungszeiten für den Aufbau eines 1,56 mm dicken Sockels und die Härtewerte nach Shore-A der jeweiligen strahlungsvernetzten Photopolymerschichten sind in Tabelle II aufgeführt.

Tabelle II

| Anwendungsbeispiel | Monomer nach Herstellungsbeispiel | Rückseitenvorbelichtungszeit für 1,56 mm Sockelhöhe | Härte nach Shore-A |
|---|---|---|---|
| 2 | 2 | 80 | 43 |
| 3 | 3 | 55 | 44 |
| 4 | 4 | 104 | 45 |
| 5 | 5 | 135 | 43 |
| 6 | 6 | 115 | 50 |
| 7 | 7 | 125 | 39 |
| 8 | 8 | 85 | 42 |
| 9 | 9 | 34 | 34 |

Vergleichsbeispiel 1

| | | |
|---|---|---|
| 94 | Gt | des in Anwendungsbeispiel 1 beschriebenen Dreiblockcopolymeren, |
| 4 | Gt | Fumarsäure-bis-(2-ethylhexylester), |
| 0,3 | Gt | 2,6-Di-tert.-butyl-p-kresol und |
| 2 | Gt | Benzildimethylketal |

werden analog zu Anwendungsbeispiel 1 zu einer Flexodruckplatte verarbeitet.

Zur Herstellung einer Flexodruckplatte mit einer Gesamtdicke von 2,66 mm, einer Relieftiefe von 1,1 mm und einer einwandfreien Reliefausbildung des 0,055-mm-Liniengitters ist eine Rückseitenvorbelichtungszeit von 294 s und eine Mindest-Bildbelichtungszeit von 40 min notwendig. Die Härte nach Shore-A der strahlungsvernetzten Photopolymerschicht beträgt nur 33.

## Patentansprüche

**1.** Strahlungsempfindliches Gemisch, enthaltend als wesentliche Bestandteile
a) mindestens ein thermoplastisches elastomeres Blockcopolymeres der allgemeinen Formeln

$(A\text{-}B)_m\text{-}A$, $(B\text{-}A)_{m+1}\text{-}B$, $(A\text{-}B)_{m+1}$ oder $(A\text{-}B)_oY$,

worin
A für einen thermoplastischen, nicht-elastomeren Polymerblock mit einer Glasübergangstemperatur von 25 °C oder darüber und

B für einen elastomeren Polymerblock mit einer Glasübergangstemperatur von 10 °C oder darunter stehen,

Y Sn oder Si ist,

m eine ganze Zahl von 1 bis 10 darstellt und

o 2 ist, wenn X Sn ist oder 4, wenn X Si ist,

b) mindestens eine mehrfach ethylenisch ungesättigte Verbindung und

c) einen Photopolymerisationsinitiator,

das dadurch gekennzeichnet ist, daß mindestens eine der mehrfach ethylenisch ungesättigten Verbindungen der allgemeinen Formel I

$$R-(O-\overset{O}{\overset{\|}{C}}-CH=CH-\overset{O}{\overset{\|}{C}}-O-X)_n-O-\overset{O}{\overset{\|}{C}}-CH=CH-\overset{O}{\overset{\|}{C}}-O-R \qquad (I)$$

entspricht, wobei

R einen geradkettigen oder verzweigten Alkylrest,

X ein geradkettiges Alkylen oder Cycloalkylen, wobei einzelne Methylengruppen durch -O-, -S-, Carbonyl oder Carbonyloxygruppen substituiert sein können, und

n 1 bis 5

bedeuten.

**2.** Strahlungsempfindliches Gemisch nach Anspruch 1, dadurch gekennzeichnet, daß R ein Alkylrest mit 1 bis 8, vorzugsweise mit 1 bis 4, C-Atomen darstellt.

**3.** Strahlungsempfindliches Gemisch nach den Ansprüchen 1 oder 2, dadurch gekennzeichnet, daß R geradkettig ist.

**4.** Strahlungsempfindliches Gemisch nach Anspruch 1, dadurch gekennzeichnet, daß X ein Alkylen mit 2 bis 20, vorzugsweise 4 bis 15, C-Atomen darstellt.

**5.** Strahlungsempfindliches Gemisch nach Anspruch 4, dadurch gekennzeichnet, daß X geradkettig ist.

**6.** Strahlungsempfindliches Gemisch nach Anspruch 1, dadurch gekennzeichnet, daß X ein insbesondere geradkettiges Polyol darstellt mit 1 bis 6 wiederkehrenden Einheiten der Formel $[OA]_{n}$-, worin A Alkylen mit 2 bis 4 C-Atomen ist.

**7.** Strahlungsempfindliches Gemisch nach Anspruch 1, dadurch gekennzeichnet, daß X ein Cycloalkylen oder Alkylencycloalkyl mit 6 bis 12 C-Atomen ist.

**8.** Strahlungsempfindliches Gemisch nach einem der Ansprüche 1 oder 7, dadurch gekennzeichnet, daß das cycloaliphatische Alkylen ein 1,4-Cyclohexyliden ist.

**9.** Strahlungsempfindliches Gemisch nach Anspruch 7, dadurch gekennzeichnet, daß das cycloaliphatische Alkylen $-CH_2-C_6H_{10}-$ oder $-CH_2-C_6H_{10}-CH_2-$ ist, wobei $C_6H_{10}$ für Cyclohexyliden, speziell 1,4-Cyclohexyliden, steht.

**10.** Strahlungsempfindliches Gemisch nach Anspruch 1, dadurch gekennzeichnet, daß das mit X bezeichnete Alkylen als Substituenten -O- oder Carbonyloxy enthält.

**11.** Strahlungsempfindliches Gemisch nach den Ansprüchen 1 oder 10, dadurch gekennzeichnet, daß das mit X bezeichnete Alkylen mindestens eine Carbonyloxygruppe aufweist und verzweigt ist.

**12.** Strahlungsempfindliches Gemisch nach Anspruch 11, dadurch gekennzeichnet, daß die eine Carbonyloxygruppe flankierenden Alkylreste mindestens 3 C-Atome und höchstens 6 C-Atome aufweisen.

13. Strahlungsempfindliches Gemisch nach einem der Ansprüche 1 bis 12, dadurch gekennzeichnet, daß die mehrfach ethylenisch ungesättigte Verbindung mindestens 2 und höchstens 6 C-C-Doppelbindungen enthält.

14. Strahlungsempfindliches Gemisch nach einem der Ansprüche 1 bis 13, dadurch gekennzeichnet, daß die mehrfach ethylenisch ungesättigte Verbindung ein zahlenmäßiges Molekulargewicht von maximal unter 5.000, vorzugsweise maximal 3.000, aufweist.

15. Strahlungsempfindliches Gemisch nach einem der Ansprüche 1 bis 14, dadurch gekennzeichnet, daß die mehrfach ethylenisch ungesättigte Verbindung mindestens 85 Gew.-% einer Verbindung gemäß der allgemeinen Formel I enthält.

16. Strahlungsempfindliches Gemisch nach einem der Ansprüche 1 bis 15, dadurch gekennzeichnet, daß die OH-Zahl der Verbindung gemäß Formel I kleiner als 1 mg KOH/g beträgt.

17. Strahlungsempfindliches Gemisch nach einem der Ansprüche 1 bis 16, dadurch gekennzeichnet, daß das Gemisch zu 1 bis 40 Gew.-%, vorzugsweise zu 2 bis 20 Gew.-%, eine mehrfach ethylenisch ungesättigte Verbindung enthält.

18. Strahlungsempfindliches Gemisch nach Anspruch 1, dadurch gekennzeichnet, daß der thermoplastische nichtelastomere Polymerblock ein Molekulargewicht von 2.000 bis 100.000 aufweist.

19. Strahlungsempfindliches Gemisch nach Anspruch 1, dadurch gekennzeichnet, daß das Gemisch 0,01 bis 10 Gew.-%, bevorzugt 0,5 bis 5 Gew.-%, eines Photoinitiators enthält.

20. Aufzeichnungsmaterial zur Herstellung von Relief- und Hochdruckplatten, dadurch gekennzeichnet, daß das strahlungsempfindliche Gemisch nach einem der Ansprüche 1 bis 19 auf einem Schichtträger aufgebracht ist und gegebenenfalls mit einer dünnen, gegebenenfalls abziehbaren Deckschicht überzogen ist.

21. Verfahren zur Herstellung eines Aufzeichnungsmaterials, dadurch gekennzeichnet, daß ein strahlungsempfindlichen Gemisch nach den Ansprüchen 1 bis 19 auf einen Schichtträger aufgebracht, gegebenenfalls eine Deckschicht darüber gezogen und - gegebenenfalls nach vollflächiger Rückseitenbelichtung - von der Vorderseite bildmäßig belichtet wird, die nichtbelichteten Teile der Schicht mit einem Entwickler entfernt werden und anschließend gegebenenfalls eine Nachbelichtung mit aktinischem Licht erfolgt.

Europäisches Patentamt

# EUROPÄISCHER RECHERCHENBERICHT

Nummer der Anmeldung

EP 90124404.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,X | DE - B2 - 2 815 678 (ASAHI KASEI KOGYO K.K.) * Gesamt * -- | 1-5, 17-21 | G 03 F 7/027<br>G 03 F 7/075<br>C 08 F 2/50<br>C 08 L 53/00 |
| X | EP - A2/A3 - 0 075 236 (BASF) * Ansprüche; Seite 9, Zeile 4 - Seite 10, Zeile 3; Seite 16, Zeilen 11-14; Seite 17, Zeile 3 - Seite 18, Zeile 28 * ---- | 1-5, 17-21 | |

| RECHERCHIERTE SACHGEBIETE (Int. Cl.4) |
|---|
| G 03 F<br>C 08 F<br>C 08 G<br>C 08 L |

Der vorliegende Recherchenbericht wurde für alle Patentansprüche erstellt.

| Recherchenort | Abschlußdatum der Recherche | Prüfer |
|---|---|---|
| WIEN | 03-05-1991 | SCHÄFER |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82